# EUROPEAN PATENT APPLICATION

(11) **EP 1 098 000 A2**
(43) Date of publication of application: **09.05.2001**
(21) Application number: 00123693.4
(22) Date of filing: 31.10.2000
(51) Int. Cl.: C12Q 1/00

(54) **Embedded metallic deposits forming an electrode set for an electrochemical sensor strip**

(30) Priority: 03.11.1999 US 433629
(71) Applicant: Roche Diagnostics Corporation, Indianapolis, IN 46250 (US)
(72) Inventor: Bhullar, Raghbir S., Indianapolis, IN 46236 (US)
(74) Representative: Jung, Michael, Dr.

(57) **Abstract**

A method of making a set of metallic deposits includes injection molding a substrate, where a pattern of channels is in a surface of the substrate, applying a metallic layer on the surface, to form metallic deposits in the pattern, and removing a portion of the metallic layer, to expose a portion of the surface. The set of metallic deposits can form an electrode set for an electrochemical sensor strip.

## Description

### BACKGROUND OF THE INVENTION

The present invention relates to embedded metallic deposits.

Electrochemical biosensors are well known. They have been used to determine the concentration of various analytes from biological samples, particularly from blood. Electrochemical biosensors are described in U.S. Patent Nos. 5,413,690; 5,762,770 and 5,798,031; as well as in International Publication No. WO99/13101, each of which are hereby incorporated by reference.

An electrochemical biosensor typically includes a sensor strip. The sensor strip includes a space that holds the sample to be analyzed, may include reagents to be released into the sample, and includes an electrode set. The electrode set normally includes an insulating substrate, electrodes that contact the sample, which have contact pads for electrically connecting the electrodes to the electronics of the electrochemical biosensor.

It is desirable for electrochemical biosensors to be able to analyze electrolytes using as small a sample as possible, and therefore it is necessary to miniaturize the sensor strip, as well as its parts, including the electrodes, as much as possible. Typically, screen printing techniques have been used to form miniaturized electrodes.

Electrodes formed by screen printing techniques can only be formed from compositions that are both electrically conductive and which are screen printable. Furthermore, screen printing techniques are typically only reliable when forming structures and patterns having a feature size of approximately 75 µm or greater. In addition, screen printing is a wet chemical process, with attendant processing and environmental costs. It would be desirable to have a new method of forming electrodes which allows for the use of different compositions, which can form features smaller than 75 µm, and does not require a wet chemical process.

Injection molding is a technique used to make shaped parts from many polymeric materials. Usually, a molten thermoplastic polymer is forced into a two-part mold. The thermoplastic cools and hardens, taking on the shape of the mold. A type of injection molding, known as reaction injection molding (RIM) is carried out using monomers or low-molecular weight polymeric precursors of a thermosetting polymer; the monomers or polymeric precursors are rapidly mixed and injected into the mold as the polymerization process takes place. Furthermore, reinforcing fibers may also be injected along with the monomers or polymeric precursors, in a process known as reinforced reaction injection molding (RRIM). Injection molding can be used to form very fine structures, such as the data encoding portions of compact discs; this type of injection molding is often referred to as microinjection molding.

### SUMMARY OF THE INVENTION

In one aspect, the invention is a set of metallic deposits, comprising a pattern of channels in a surface of a substrate, and metallic deposits in the pattern. Portions of the surface are exposed, and the substrate comprises a polymer.

In another aspect, the invention is an electrode set, comprising an electrode pattern in a surface of a substrate, and metallic deposits in the pattern. The substrate comprises a polymer.

In still another aspect, the invention is a method of making a set of metallic deposits, comprising injection molding a substrate, where a pattern of channels is in a surface of the substrate, applying a metallic layer on the surface, to form metallic deposits in the pattern, and removing a portion of the metallic layer, to expose a portion of the surface.

In yet another aspect, the invention is a mold insert, comprising a metal, where a reverse electrode pattern is in a surface of the mold insert.

An advantage of the present invention is that it allows for the possibility of small feature sizes.

As used herein, the term "pattern" means one or more intentionally formed channels or raised ridges having a feature size, for example, a single linear channel having a constant width, where the smallest width is the feature size. Not included in the term "pattern" are natural, unintentional defects.

The term "channel" refers to a portion of the surface that is depressed relative to adjacent portions of the surface. The phrase "pattern of channels" refers to a pattern formed of one or more channels. A pattern of channels has two parts: the channel or channels, and the remaining parts of the pattern, referred to as an "island" or "islands".

As used herein, the phrase "feature size" is the smallest width of a channel or raised ridge found in a pattern.

As used herein, the phrase "electrode pattern" is a pattern of channels, which when filled with a metallic material includes at least two, for example 2 to 60, or 3 to 20, electrodes which are not electrically connected to each other, but each of which includes its own contact pad. A "reverse electrode pattern" is the negative impression of an electrode pattern, i.e., where an electrode pattern has channels, a reverse electrode pattern has raised ridges.

The phrase "injection moldable polymer" refers to a polymer which can be formed by an injection molding process, and includes not only thermoplastic polymers, but also polymer which are synthesized during the forming process, i.e., polymers formed by during reactive injection molding.

As used herein, the phrase "metallic channel" refers to a channel filled with a material that is a metallic conductor of electricity, such as a pure metal or alloy.

As used herein, the phrase "electrode set" is a set of at least two electrodes, for example 2 to 60, or 3 to 20, electrodes. These electrodes may be, for example, a working electrode, a reference electrode, and/or a counter electrode.

Other features and advantages of the present invention will become apparent from the following detailed description. It should be understood, however, that the detailed description and the specific examples, while indicating embodiments of the invention, are given by way of illustration only, since various changes and modifications within the spirit and scope of the invention will become apparent to those skilled in the art from this detailed description.

### BRIEF DESCRIPTION OF THE DRAWINGS

The following drawings form part of the present specification and are included to further demonstrate certain aspects of the present invention. The invention may be better understood by reference to one or more of these drawings in combination with the detailed description of specific embodiments presented herein:
Figure 1 illustrates a side view of a master mold blank;
Figure 2 illustrates a side view of a master mold;
Figure 3 illustrates a side view of formation of a substrate mold insert;
Figure 4 illustrates a side view of a substrate mold insert;
Figure 5 illustrates a side view of a molding tool with a substrate mold insert;
Figure 6 illustrates a side view of the formation of a metallic layer on a substrate;
Figure 7 illustrates a side view of a set of metallic deposits;
Figure 8 illustrates a side view of a lid mold insert;
Figure 9 illustrates a side view of a molding tool with a lid mold insert;
Figure 10 illustrates a side view of a hydrophilisized lid;
Figure 11 illustrates a side view of alignment of a lid with a set of metallic deposits;
Figure 12 illustrates a side view of a sensor;
Figure 13 illustrates a perspective view of an embodiment of a sensor having a lid with a hole;
Figure 14 illustrates a perspective view in partial cutaway of an embodiment of a sensor having a lid with a hole; and
Figure 15 illustrates a schematic of three views of an electrode set.

### DETAILED DESCRIPTION OF THE INVENTION

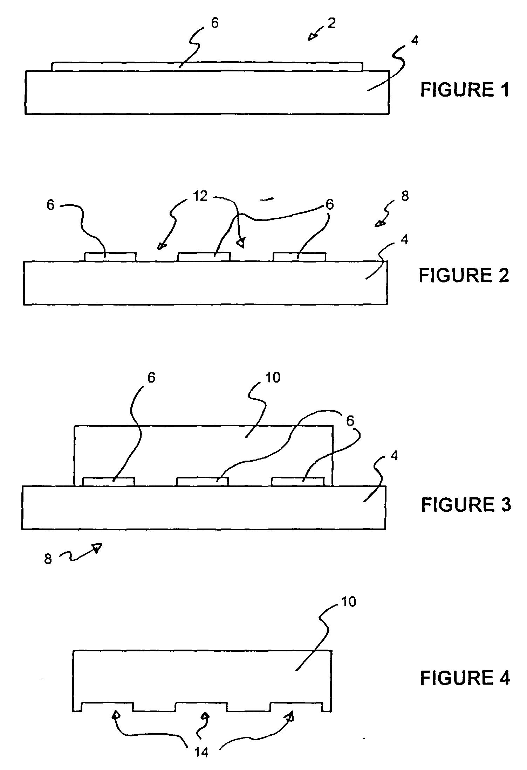

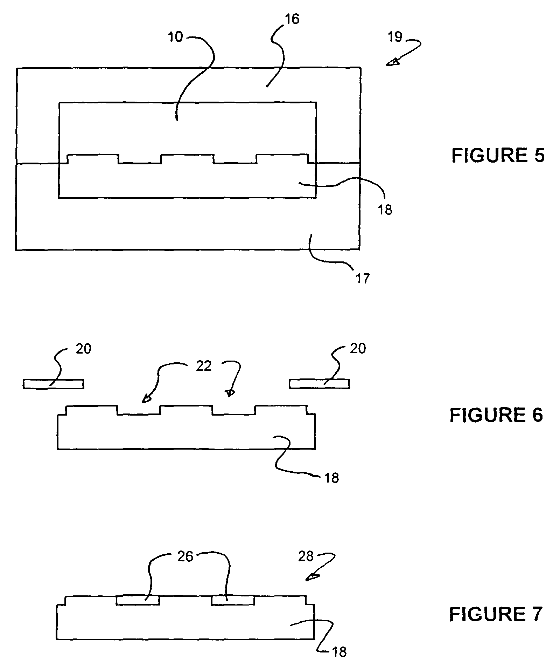

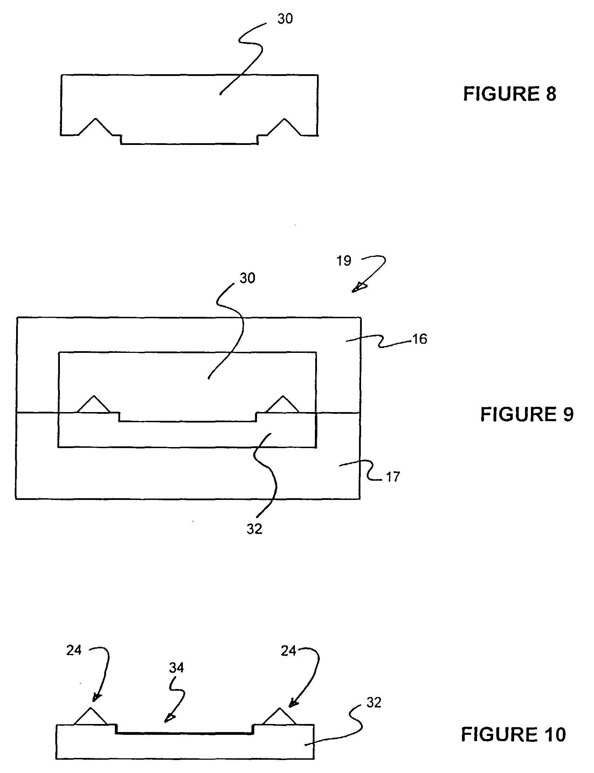

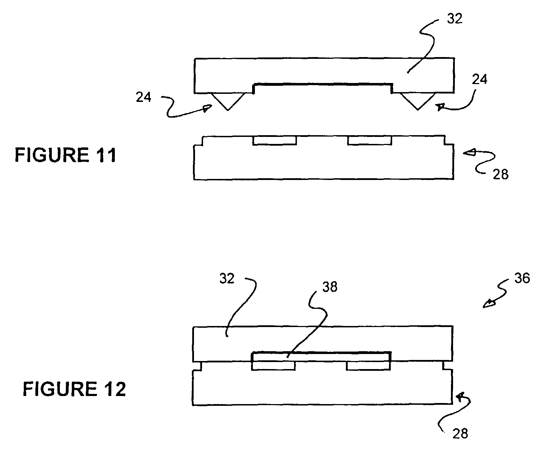

Figures 1 to 4 illustrate how a substrate mold insert is made. Figures 5 to 7 illustrate how an electrode set is made. Figures 8 to 10 illustrate how a lid is made. Figures 11 and 12 illustrate how a sensor is made.

Figure 1 illustrates a master mold blank **2**, including a surface **4** with a layer of photoresist **6** on the surface. A pattern of channels, such as an electrode pattern, is then formed in the photoresist layer by exposing and developing the photoresist using a mask. The resulting pattern **12** in the photoresist **6**, on the surface **4** forms a master mold **8**, illustrated in Figure 2. The surface may be made from any solid material, including glass, silicon, metal or a polymer. Either a negative or positive photoresist may be used.

Figure 3 illustrates the master mold **8** covered with a thick material layer, to form the substrate mold insert **10**. The thick material that forms the substrate mold insert may be made of any heat resistant material which will tolerate the conditions inside the mold during injection molding. Examples include metals, such as copper, nickel, or gold. The thick material layer may be formed by electroforming or physical vapor deposition, or in the case of a ceramic, by pressure application to form a green body. In the case of a ceramic, the substrate mold insert may be fired before use, and dimensional changes resulting from firing can be compensated beforehand by selecting the original dimensions of the master mold. Figure 4 illustrates the substrate mold insert **10**, having a negative image of the pattern **14**, i.e., in the case of an electrode pattern, the negative image will be a reverse electrode pattern.

Figure 5 illustrates a mold tool **19**, having a first part **16** and a second part **17**, into which the substrate mold insert **10** fits. The mold tool, together with the substrate mold insert, forms a space that will define the shape of the substrate **18**. A material is injection molded into the space, to form the substrate **18**, as illustrated in Figure 5. The substrate will have a pattern corresponding to the negative image of the substrate mold insert.

The substrate **18** comprises a polymeric material, and may also include reinforcing materials, such as glass fibers. Preferably, the substrate comprises a thermoplastic polymeric material, for example acrylonitrile butadiene styrene (ABS), acetal, acrylic, polycarbonate (PC), polyester, polyethylene, fluroplastic, polyimide, nylon, polyphenylene oxide, polypropylene (PP), polystyrene, polysulphone, polyvinyl chloride, poly(methacrylate), poly(methyl methacrylate), or mixture or copolymers thereof. More preferably, the substrate includes a polycarbonate, such as those used in making compact discs. Specific examples of polycarbonates include MAKROLON™ 2400 from BAYER AG of Leverkusen, Germany; and NOVAREX™ 7020 HF, from MITSUBISHI ENGINEERING-PLASTICS CORPORATION of Tokyo, Japan. Most preferably, the substrate does not contain any reinforcing material, and only contains a thermoplastic polymeric material, such as a polycarbonate. The material injection molded into the space, to form the substrate, is either the material of the substrate, such as a thermoplastic polymeric material, or components which will react to form the material of the substrate, such as monomers or polymeric precursors.

Once the substrate is formed, the molding tool is opened to release the substrate. As illustrated in Figure 6, a metallic layer **22** is then formed on the substrate **18**. The metallic layer may be formed by, for example, evaporation or by sputtering. A mask **20** may be used to prevent formation of the metallic layer on portions of the substrate that do not have a pattern.

The metal layer may have almost any thickness, but preferably has a thickness at least as large as the depth of the channels of the pattern in the substrate.

Figure 7 illustrates a set of metallic deposits **28**. The set of metallic deposits corresponds to the pattern of the substrate **18**, and includes metallic deposits **26** in the substrate. In the case where the pattern **18** is an electrode pattern, the set of metallic deposits is an electrode set, and the metallic deposits form one or more electrodes. The set of metallic deposits is formed by removing those parts of the metallic layer **22** outside of the channels of the pattern shown in Figure 6, causing portions of the substrate surface outside the pattern to be exposed. The excess metallic layer may be remove by, for example, milling or chemical/mechanical polishing. Preferably, the metallic deposits have a thickness which is the same as the depth of the channels of the pattern in the substrate, so that the set of metallic deposits and substrate surface together form a flat surface.

Figure 8 illustrates a lid mold insert **30**. The lid mold insert may be made of any of the materials from which the substrate mold insert is made. The lid mold insert may be formed by precision milling, lithography or laser ablation.

Figure 9 illustrates a mold tool **19**, having a first part **16** and a second part **17**, into which the lid mold insert **30** fits. The mold tool, together with the lid mold insert, forms a space that will define the shape of the lid **32**. A material is injection molded into the space, to form the lid **32**, as illustrated in Figure 9. The choice of materials of which the lid is made, as well as what materials are injection molded into the space to for the lid, are the same as those of the substrate. The lid and the substrate may be made of the same or different materials.

The inside surface **34** of the lid **32** is may be hydrophilisized, as illustrated in Figure 10. This causes an aqueous solution to wet the inside surface **34**. Hydrophilisation may be carried out by, for example, application of a surfactant, or treatment with a plasma formed from a gas containing oxygen. This plasma can also be used to clean the electrode surfaces. Also illustrated in Figure 10 are optional energy directors **24** and **24**, which are a part of the lid **32**.

Figure 11 illustrates aligning the lid **32** with the set of metallic deposits **28**. As shown, the inside surface (here hydrophilisized) is aligned over a section of the metallic deposits. The lid **32** and the set of metallic deposits **28** are bonded together, and when the set of metallic deposits is an electrode set, they form a sensor **36**, as illustrated in Figure 12. A capillary channel **38** forms between the inside surface of the lid **32** and a portion of the electrode set **28**.

This capillary channel can draw a fluid sample from its opening onto the metallic deposits of the electrode set.

The lid may be bonded to the electrode set a variety of was, including ultrasonic welding, or using an adhesive or a solvent. When the lid had energy directors, ultrasonic welding causes the material that forms the energy directors to bond the electrode set and the lid. When bonding with a solvent, the solvent will dissolve a portion of the material of the lid, the substrate, or both, causing them to adhere as the solvent evaporates. Preferably, a groove or channel is included for solvent or adhesive bonding.

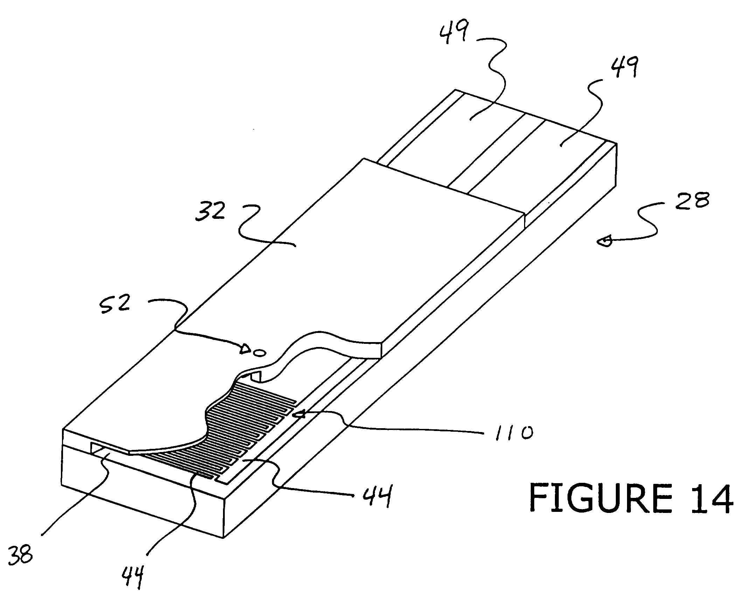

Figure 14 illustrates an embodiment of an electrode set **28**. As shown, the electrode set includes two electrodes **44** and **44**. The electrodes have contact pads **49** and **49**, that are electrically connected to the sensing region **110** of the electrode. Also illustrated is lid **32** that covers the electrodes, and includes a vent **52**, and the lid together with the substrate define a capillary channel **38**. The vent allows air to escape when the sample is applied to the opening of the capillary channel and flows towards the sensing region.

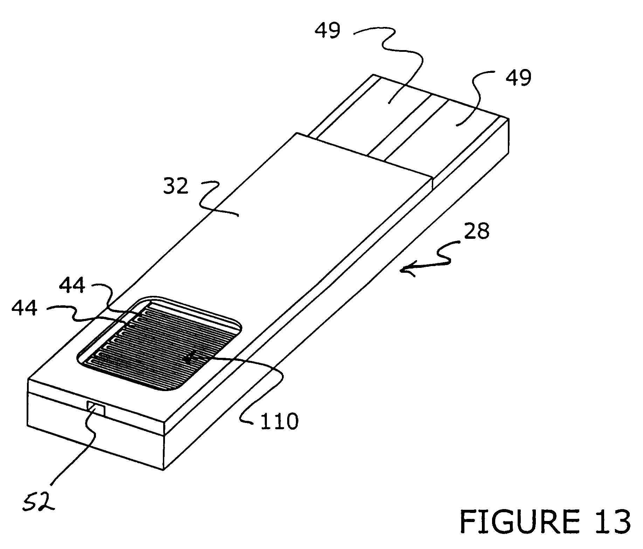

In a different embodiment, the lid has an opening through its top, and this opening is aligned over a portion of the metallic deposits, and a fluid sample may be placed through this opening directly onto the metallic deposits. This is illustrated in Figure 13, which shows an electrode set **28**, including two electrodes **44** and **44**. The electrodes have contact pads **49** and **49**, that are electrically connected to the sensing region **110** of the electrode. Also illustrated is lid **32** that covers the first and second electrodes, exposing only the sensing region and the contact pads; the lid together with the substrate also define a vent **52**, which allows air to escape when the sample is applied to the sensing region.

A sensor may be used alone as a sensor strip for use in an electrochemical sensor. Alternatively, the sensor may be attached to a base, with the lid facing away from the base. The sensor may be attached to the base with an adhesive, such as an adhesive foil. Furthermore, a reagent may be placed onto the sensor region of the electrode set.

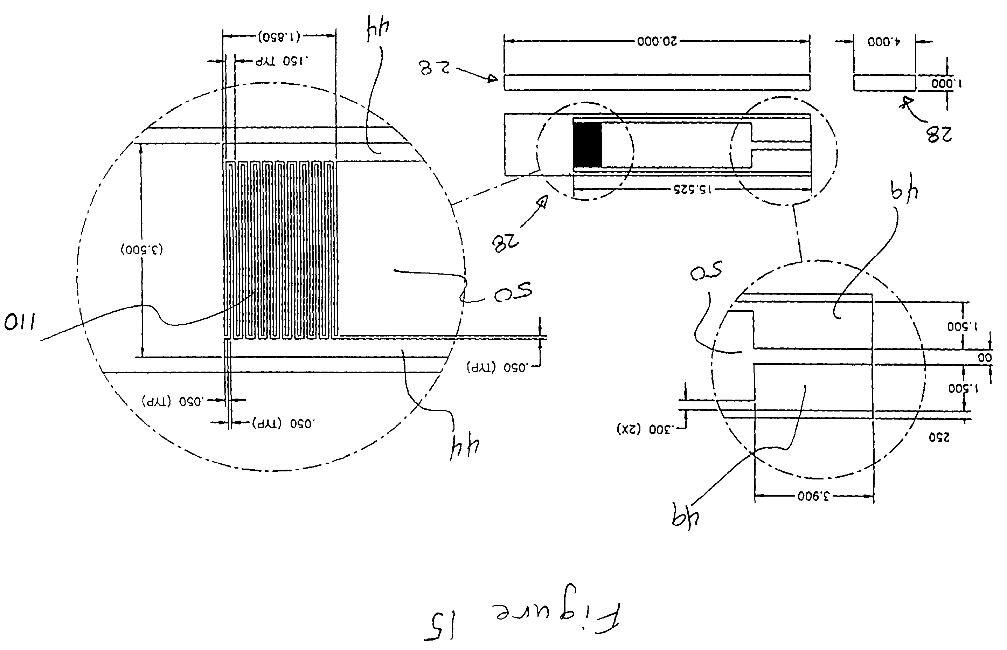

Figure 15 illustrates three views of an electrode set **28**, showing the details of an electrode pattern. Shown in the figure are two electrodes **44** and **44**, each having a contact pad **49** and **49** and a sensing region **110** in electrical contact. Those portions of the pattern that do not have an electrode (and therefore the surface of the substrate in that portion did not have a channel) are designated as island (or islands) **50**. Although these regions are referred to as an island (or islands), they need not be completely surrounded by channels in the substrate.

There is no electrical contact between the electrodes. Each electrode **44** is formed from a metallic channel. The distances shown in the figure are in millimeters. In the sensing region, the electrodes (and therefore also the metallic deposits) are illustrated as having a width of 0.050 mm (50 µm). Preferably, the width may be 1 µm to 1 mm, more preferably 5 µm to 300 µm, most preferably 10 µm to 100 µm. Furthermore, the width may vary in any given electrode set. The smallest width in a pattern corresponds to the feature size, since it is the smallest intentional feature in the pattern. In the sensing region, the electrodes form interlacing fingers, in a rectilinear pattern.

The values for the dimensions illustrated in Figure 14 are for a single specific embodiment, and these values may be selected as need for the specific use. For example, the length of the electrode set may be 1.5 to 250 mm, the width may be 0.4 to 40 mm, the gap between the contact pads maybe 1 µm to 5 mm, and the width of each contact pad may be 0.1 to 20 mm. The electrode pattern shown in Figure 14 is symmetric; however this is not required, and irregular or asymmetric patters (or electrode shapes) are possible.

The metallic channel and metallic layer may contain pure metals or alloys, or other materials which are metallic conductors. Examples include aluminum, carbon (such as graphite), cobalt, copper, gallium, gold, indium, iridium, iron, lead, magnesium, mercury (as an amalgam), nickel, niobium, osmium, palladium, platinum, rhenium, rhodium, selenium, silicon (such as highly doped polycrystalline silicon), silver, tantalum, tin, titanium, tungsten, uranium, vanadium, zinc, zirconium, mixtures thereof, and alloys or metallic compounds of these elements. Preferably, the metallic layer includes gold, platinum, palladium, iridium, or alloys of these metals, since such noble metals and their alloys are unreactive in biological systems. The metallic layer may be any thickness, but preferably is 10 nm to 1 mm, more preferably, 20 nm to 100 µm, or even 25 nm to 1 µm. The depth of the pattern formed in substrate is preferably 10 nm to 1 mm, more preferably, 20 nm to 100 µm, or even 25 nm to 1 µm. Preferably, the metallic layer is at least as thick as the pattern of channels formed in the substrate is deep; however, it is possible for the metal layer to be thicker or thinner than the channels are deep. The metallic deposits will have a maximum depth corresponding to the thickness of the metal layer, but through etching or milling, the depth of the metallic deposits may be less deep than the metallic layer is thick.

The metallic layer, and/or the metal channels may be coated or plated with additional metal layers. For example, the metallic layer may be copper; subsequently, the copper may be plated with a titanium/tungsten layer, and then a gold layer, and then milled, to form the desired electrodes. Preferably, however, only a single layer of gold is used, which is directly in contact with the substrate, since it allows for the entire elimination of wet chemical steps for the formation of the electrode sets.

Unlike structures formed by screen printing, the metallic deposits and therefore the electrodes of the electrodes sets, are set into the substrate; in screen printing all structures rest on top of the surface of the substrate. Preferably, the metallic deposits are completely within groves in the surface of the substrate, i.e. the metallic deposits are inlaid within the surface of the substrate. However, if metal is coated or plated onto the metallic deposits, they may extend out above the plane of the surface of the substrate.

The base is a supporting structure, and is preferably made of flexible polymer material, with a thickness sufficient to provide support to the sensor strip, for example polyester with a thickness of 6 mils. The adhesive foil is also a flexible polymer having a surfaces covered with an adhesive; these materials are also well known to those of ordinary skill in the art.

The reagent is optional, and may be used to provide electrochemical probes for specific analytes. The starting reagents are the reactants or components of the reagent, and are often compounded together in liquid form before application to the sensor region. The liquid may then evaporate, leaving the reagent in solid form. The choice of specific reagent depends on the specific analyte or analytes to be measure, and are well known to those of ordinary skill in the art. For example, a reagent for measurement of glucose in a human blood sample contains 62.2 mg polyethylene oxide (mean molecular weight of 100-900 kilodaltons), 3.3 mg NATROSOL 250 M, 41.5 mg AVICEL RC-591 F, 89.4 mg monobasic potassium phosphate, 157.9 mg dibasic potassium phosphate, 437.3 mg potassium ferricyanide, 46.0 mg sodium succinate, 148.0 mg trehalose, 2.6 mg TRITON X-100 surfactant, and 2,000 to 9,000 units of enzyme activity per gram of reagent. The enzyme is prepared as an enzyme solution from 12.5 mg coenzyme PQQ and 1.21 million units of the apoenzyme of quinoprotein glucose dehydrogenase, forming a solution of quinoprotein glucose dehydrogenase. This reagent is described in WO 99/30152, pages 7-10.

The processes and products described include disposable biosensors, especially for use in diagnostic devices. However, also included are electrochemical sensors for non-diagnostic uses, such as for measuring an analyte in any biological, environmental, or other, sample. Furthermore, also included is any substrate containing metallic deposits, preferably of a noble metal (gold, platinum, palladium, iridium, alloys thereof) in direct contact with an insulating substrate, such as a polymer. Such laminates can have a variety of electrical function, including use as electrodes, electrical wires or connectors, microwave reflectors, etc. Preferably, these substrates containing metallic deposits have a feature size of 100 µm or less, more preferably 1 to 100 µm, even more preferably 75 µm or less, including 5 to 50 µm, or even 5 to 20 µm.

## Claims

1. A method of making a set of metallic deposits, comprising:
injection molding a substrate, wherein a pattern of channels is created in a surface of said substrate, and said pattern of channels comprises at least one channel and at least one island;
forming a metallic layer on said surface, to form metallic deposits in said pattern; and removing a portion of said metallic layer, to expose at least a portion of said at least one island.

2. The method of Claim 1, wherein said set of metallic deposits is an electrode set, and said pattern is an electrode pattern.

3. The method of Claim 1 or 2, wherein said metallic layer comprises at least one metal selected from the group consisting of gold, platinum, palladium and iridium.

4. The method of Claim 1, 2 or 3, wherein said substrate comprises a thermoplastic polymer.

5. The method of Claim 4, wherein said thermoplastic polymer is a polycarbonate.

6. The method of Claim 2, wherein said metallic deposits have a width of 1 to 100 µm.

7. A method of making a sensor, comprising:
forming an electrode set by the method of Claim 2 or 4,and
bonding a lid to said electrode set.

8. The set of metallic deposits produced by the method of Claim 1.

9. The electrode set produced by the method of Claim 2 or 4.

10. The sensor produced by the method of Claim 7.

11. A set of metallic deposits, comprising:
a pattern of channels in a surface of a substrate, and
metallic deposits in said pattern,
wherein portions of said surface are exposed, and
said substrate comprises a polymer.

12. The set of metallic deposits of Claim 11, wherein said polymer is a thermoplastic polymer.

13. The set of metallic deposits of Claim 12, wherein said polymer is a polycarbonate.

14. The set of metallic deposits of Claim 11 or 13, wherein said metallic deposits comprise at least one metal selected from the group consisting of gold, platinum, palladium and iridium.

15. An electrode set, comprising:
an electrode pattern in a surface of a substrate, and
metallic deposits in said pattern,
wherein said substrate comprises a polymer.

16. The electrode set of Claim 15, wherein said polymer is a thermoplastic polymer.

17. The electrode set of Claim 16, wherein said polymer is a polycarbonate.

18. A mold insert, comprising a metal,
wherein a reverse electrode pattern is in a surface of said mold insert.

19. A set of metallic deposits, comprising:
a pattern of channels in a surface of a substrate, and
metallic deposits in said pattern,
wherein portions of said surface are exposed, and
said pattern of channels are formed by injection molding.

20. The set of metallic deposits of Claim 19, wherein said substrate comprises a thermoplastic polymer.

21. The set of metallic deposits of Claim 20, wherein said substrate comprises a polycarbonate.

22. The set of metallic deposits of Claim 19 or 21, wherein said metallic deposits comprise at least one metal selected from the group consisting of gold, platinum, palladium and iridium.

23. An electrode set, comprising:
an electrode pattern in a surface of a substrate, and
metallic deposits in said pattern,
wherein said electrode pattern is formed by injection molding.

24. The electrode set of Claim 15 or 23, wherein portions of said surface are exposed.

25. The electrode set of Claim 23, wherein said substrate comprises a thermoplastic polymer.

26. The electrode set of Claim 25, wherein said substrate comprises a polycarbonate.

27. The electrode set of Claim 15, 17, 23 or 26, wherein said metallic deposits comprise at least one metal selected from the group consisting of gold, platinum, palladium and iridium.

28. The electrode set of Claim 15 or 23, wherein said metallic deposits have a width of 1 to 100 µm.

29. A sensor, comprising:
the electrode set of Claim 15, 23 or 27, and
a lid, on said electrode set.
